# EUROPÄISCHE PATENTANMELDUNG

(11) **EP 0 754 869 A1**
(43) Veröffentlichungstag der Anmeldung: **22.01.1997**
(21) Anmeldenummer: 96111311.5
(22) Anmeldetag: 12.07.1996
(51) Int. Cl.: F16B 21/20, G01R 1/067

(54) **Vorrichtung zum lösbaren Verbinden zweier Bauteile**

(30) Priorität: 19.07.1995 DE 19526414
(71) Anmelder: SIEMENS AKTIENGESELLSCHAFT, 80333 München (DE)
(72) Erfinder: Rapp, Lothar, 81477 München (DE)

(57) **Zusammenfassung**

Die Vorrichtung besteht aus einer bügelartigen Spanneinrichtung (7) die an seitlichen Haltestiften (8) verankert wird. Die Spanneinrichtung (7) weist eine Spannfeder (5) auf, die mit Federfingern (9) bis über die Haltestifte (8) ragt. Die Enden der Federfinger (9) sind zwischen zwei Klemmplatten (4) verschiebbar geführt. Die Spannfeder (5) und die Klemmplatten (4) sind mit Klemmbohrungen (10) versehen, durch die die Haltestifte (8) hindurchragen. Eine mit dem Bereich an der Spannfeder abgestützte Schraube drückt das Bauteil (2) gegen das Basisbauteil (1), wobei die Spannfeder vom Bauteil (2) weg ausgelenkt wird. Dadurch werden die Enden der Federfinger (9) zur Mitte hin gezogen und verklemmen die Haltestifte zwischen den Klemmbohrungen (10) der Klemmplatten (4) und der Federfinger (9). Damit ist die Spanneinrichtung (7) selbsthemmend und sicher an den Haltestiften (8) verankert.

## Beschreibung

Die Erfindung bezieht sich auf eine Vorrichtung zum lösbaren Verbinden eines Bauteils mit einem Basisbauteil, wobei die Vorrichtung eine bügelartige Spanneinrichtung aufweist, die am Basisbauteil verankerbar ist und das Bauteil übergreift und wobei sich zumindest eine Spannschraube an der Spanneinrichtung abstützt und gegen das andere Bauteil schraubbar ist.

Eine derartige Vorrichtung ist z.B. bei Kabelschellen bekannt, bei denen ein bügelartiges Druckstück ein oder mehrere Kabel übergreift und mittels Schrauben gegen ein Gehäuse verspannbar ist. Die Kabelschellen sind z.B. für einen Maximaldurchmesser ausgelegt, wobei die Spannschrauben entsprechend lang sind. Bei dünneren Kabeln müssen die Spannschrauben tiefer eingeschraubt werden, um die Klemmweite zu verringern.

Außerdem ist durch die US-PS 5 289 844 eine Spanneinrichtung für ein Fahrzeugsteuerventil bekannt geworden, bei dem ein Bauteil mit einem Basisbauteil mittels einer bügelartigen Spanneinrichtung verbindbar ist, die mittels einer zentralen Spannschraube am Basisbauteil verankert ist. Die blattfederartige Spanneinrichtung weist sternförmig abstehende Federfinger auf, die sich am Bauteil abstützen. Beim weiteren Eindrehen der Spannschraube in das Basisbauteil wird die Spannfeder in ihrem Mittelbereich elastisch ausgelenkt.

Der Erfindung liegt die Aufgabe zugrunde, eine Vorrichtung zu schaffen, durch die das Bauteil mit geringem Schraubaufwand schnell mit dem Basisbauteil verspannt werden kann.

Diese Aufgabe wird durch Erfindung gemäß Anspruch 1 gelöst. Die Erfindung ermöglicht eine besonders einfache und schnelle Handhabung der Spanneinrichtung. Die Haltestifte sind z.B. zu beiden Seiten des Bauteils angeordnet. Die Spanneinrichtung kann zunächst bis zur Anlage am Bauteil auf die Haltestifte aufgeschoben werden und danach durch Verdrehen der Spannschraube fixiert werden. Dabei ist der zum Spannen der Teile erforderliche geringe Schraubenhub unabhängig von der Dicke des Bauteils und des Basisbauteils. Die Vorrichtung eignet sich daher besonders zum schnellen Spannen und Lösen von Bauteilen in Testeinrichtungen mit häufigem Bauteilwechsel z.B. zum Testen von integrierten elektronischen Schaltungsbausteinen, die mit ihren Anschlußelementen gegen Kontaktflecken einer Leiterplatte gedrückt werden.

Der Abstand der Klemmplatten kann z.B. durch Distanzstücke festgelegt werden, deren Dicke etwas größer ist, als die Dicke der Spannfeder. Durch die Auslenkung der Spannfeder im Mittelbereich werden die Enden der Finger zur Mitte hin gezogen. Die Haltestifte sind relativ schlank und dadurch seitlich auslenkbar. Beim Verschieben der Enden der Finger werden die Haltestifte gegen die Klemmbohrungen der Klemmplatten gedrückt und somit zwischen den Klemmplatten und den Federfingern transversal verspannt, wodurch die Haltestifte von der Spanneinrichtung krallenartig umklammert werden. Zwischen der Auslenkbewegung des Mittelbereiches und den Verschiebebewegungen der Federfinger besteht ein Übersetzungsverhältnis, daß eine hohe Klemmkraft ermöglicht. Mit der Zunahme der Spannkraft erhöht sich auch entsprechend die Klemmkraft, so daß die Klemmeinrichtung selbsthemmend sicher an den Haltestiften verankert werden kann. Der erforderliche Schraubenhub ist nicht größer als der kurze Federweg.

Vorteilhafte Weiterbildungen der Erfindung sind in den Ansprüchen 2 bis 5 gekennzeichnet.

Durch die Weiterbildung nach Anspruch 2 wird die Spannkraft auf eine größere Fläche verteilt, so daß z.B. ein empfindliches Bauteil mit einem Gehäuse von geringerer Festigkeit unbeschädigt bleibt. Ein derartiges Druckstück kann z.B. auch als Kühlkörper für einen integrierten Schaltungsbaustein ausgebildet sein, der gegen eine Leiterplatte gespannt wird.

Durch die Weiterbildung nach Anspruch 3 ist die Spannschraube an der Spannfeder verankert und kann ohne weitere Zusatzteile auf das zu spannende Bauteil einwirken.

Durch die Weiterbildung nach Anspruch 4 kann auf das Gewindestück verzichtet werden.

Die Federfinger nach Anspruch 5 ermöglichen eine hohe Spannkraft und sichere Verankerung der Spanneinrichtung die Haltestifte sind z.B. in den Eckbereichen des Schaltungsbausteines angeordnet, in denen keine Anschlußelemente mit abgehenden Leiterbahnen vorgesehen sind.

Ein Ausführungsbeispiel der Erfindung ist in der Zeichnung dargestellt und wird im folgenden näher erläutert. Es zeigen:
- Figur 1: eine teilweise geschnittene Seitenansicht einer Einrichtung zum Verbinden zweier Bauteile mit den Bauteilen,
- Figur 2 und 3: Teilansichten der Vorrichtung nach Figur 1 in zwei verschiedenen Phasen,
- Figur 4: eine Draufsicht auf die Vorrichtung nach Figur 1.

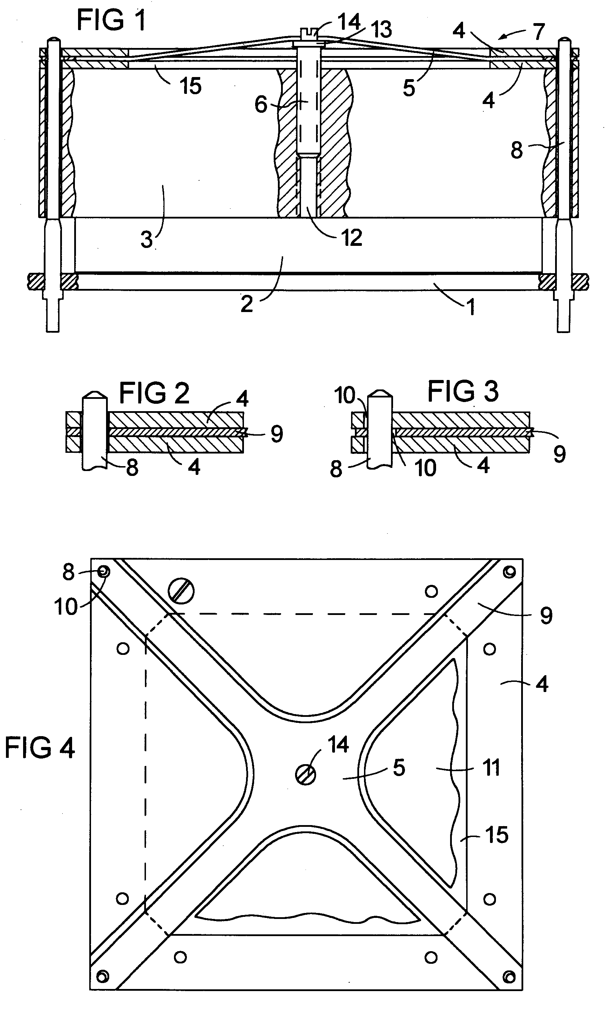

Nach den Figuren 1 bis 4 besteht eine Einrichtung zum lösbaren Verbinden eines Basisbauteils 1 mit einem Bauteil 2 im wesentlichen aus einem Druckstück 3, Klemmplatten 4, einer Spannfeder 5 und einer Spannschraube 6. Das Basisbauteil (1) ist hier als Leiterplatte ausgebildet, an der das als integrierter Schaltungsbaustein ausgebildete Bauteil (2) befestigt ist. Das als Kühlkörper dienende Druckstück 3 ist auf die der Leiterplatte 1 abgewandte Seite des Bauteils 2 aufgesetzt. Die Klemmplatten 4 mit der Spannfeder 5 sind auf das Druckstück 3 aufgesetzt. Die Klemmplatten 4, die Spannfeder 5 und die Spannschraube 6 bilden eine Spanneinrichtung 7, die so breit ausgeführt ist, daß sie die Haltestifte 8 überdeckt. Diese durchragen das Druckstück 3 und die Klemmplatten 4.

Die Spannfeder 5 ist als Blattfeder ausgebildet, die eine kreuzförmige Stanzkontur aufweist, bei der vom mittleren Kreuzungsbereich Federfinger 9 bis über die Haltestifte 8 sternförmig abstehen. Die freien Enden der Federfinger 9 sind zwischen den rahmenförmig geschnittenen Klemmplatten 4 verschiebbar geführt. Die Klemmplatten 4 und die Federfinger 9 weisen Klemmbohrungen 10 auf, durch die die Haltestifte 8 mit Spiel hindurchragen. Zwischen den beiden Klemmplatten 4 sind in den Zwischenräumen zwischen den Federfingern 9 Distanzecken 11 von etwas größeren Dicke als die Spannfeder 5 eingesetzt. Die Haltestifte 8 sind mit seitlichem Spiel durch das Druckstück 3 hindurchgeführt und entsprechend seitlich auslenkbar.

Die Spannschraube 6 ist in eine Gewindebohrung 12 des Druckstücks 3 eingeschraubt. Sie weist an ihrem äußeren Ende einen verbreiterten Kragen 13 auf, an dem sich die Spannfeder 5 im Kreuzungsbereich der Federfinger 9 mit ihrer dem Druckstück 3 zugewandten Seite abstützt. Die Spannfeder 5 ist an dieser Stelle mit einem Durchbruch versehen, durch den ein Betätigungskopf 14 der Spannschraube 6 hindurchragt, so daß diese von außen her problemlos mittels eines Schraubenziehers rotiert werden kann.

Die miteinander verschraubten Klemmplatten 4 weisen einen großflächigen zentralen Durchbruch 15 auf. Der zentrale Kreuzungsbereich der Spannfeder 5 kann durch die Spannschraube 6 vom Druckstück 3 weg in den Durchbruch 15 hineingedrückt werden. Dabei werden die Enden der Federfinger 9 zur Mitte hin gezogen, wodurch die Enden der Haltestifte 8 zwischen den Klemmplatten 4 und den Federfingern 9 krallenartig eingeklemmt werden. Durch die flache Auslenkung der Spannfeder 5 sind die Klemmkräfte so stark, daß die Teile selbsthemmend miteinander verbunden sind. Das bedeutet, daß die Klemmkräfte jede Zunahme der Schraubkraft sicher kompensieren.

Diese Klemmbefestigung hat den Vorteil, daß die Klemmeinrichtung bei entspannter Spannfeder 5 zunächst leicht auf die Haltestifte 8 bis zum Anschlag aufgesetzt werden kann. Das Befestigen und Spannen der Einrichtung wird mit einer einzigen Schraubbewegung durchgeführt. Die Vorrichtung ist ebenso leicht durch Zurückdrehen der Spannschraube 6 lösbar. Damit kann das Bauteil 2 nach dem Testen der Baugruppe leicht wieder demontiert werden.

## Patentansprüche

1. Vorrichtung zum lösbaren Verbinden eines Bauteils (2) mit einem Basisbauteil (1),
wobei die Vorrichtung eine bügelartige Spanneinrichtung aufweist, die am Basisbauteil (1) verankerbar ist und das Bauteil (2) übergreift und
wobei sich zumindest eine Spannschraube (6) an der Spanneinrichtung (7) abstützt und gegen das Basisbauteil (1) schraubbar ist,
**dadurch gekennzeichnet,**
daß die Vorrichtung zumindest zwei Haltestifte (8) aufweist, die am Basisbauteil (1) verankerbar sind,
daß die Spanneinrichtung (7) eine blattfederartige Spannfeder (5) aufweist, die mit Federfingern (9) versehen ist, deren freie Enden an den Haltestiften (8) befestigbar sind,
daß die Spannschraube (6) im Mittelbereich der Spannfeder(5) angeordnet ist,
und den Mittelbereich in die dem Basisbauteil (1) abgewandte Richtung elastisch auslenkt,
daß die Enden der Federfinger (9) zwischen zwei Klemmplatten (4) verschiebbar geführt sind, deren Abstand zueinander etwas größer als die Materialdicke der Federfinger (9) ist,
daß die Federfinger (9) und die Klemmplatten (4) sich überdeckende Klemmbohrungen (10) aufweisen, in die die Haltestifte (8) mit Spiel einsetzbar sind, und
daß die Enden der Federfinger (9) beim Auslenken des Mittelbereichs soweit transversal zu den Haltestiften (8) verschiebbar sind, daß die Haltestifte (8) zwischen den Klemmplatten (4) und den Federfingern (9) einklemmbar sind.

2. Vorrichtung nach Anspruch 1,
**dadurch gekennzeichnet,**
daß zwischen der Spannschraube (6) und dem Bauteil (2) eine der Oberfläche des Bauteils (2) angepaßtes Druckstück (3) vorgesehen ist.

3. Vorrichtung nach Anspruch 1 oder 2,
**dadurch gekennzeichnet,**
daß an der Spannfeder ein Gewindestück verankert ist, durch das die Spannschraube hindurch geschraubt ist und daß sich das freie Ende der Spannschraube am Bauteil bzw. dem Druckstück abstützt.

4. Vorrichtung nach Anspruch 1 oder 2,
**dadurch gekennzeichnet,**
daß die Spannschraube (6) in eine Gewindebohrung (12) des Druckstücks (3) eingeschraubt ist und sich mit seinem anderen Ende an der Spannfeder abstützt.

5. Vorrichtung nach Anspruch 1, 2 oder 3,
**dadurch gekennzeichnet,**
daß die Haltestifte (8) in den vier Eckbereichen des quaderförmig ausgebildeten Bauteils (2) angeordnet sind und daß die Spannfeder(5) eine kreuzförmige Schnittkontur aufweist, bei der die Federfinger (9) von einem mittleren Kreuzungsbereich sternförmig in die Richtung der Haltestifte (8) abstehen.
